# EUROPÄISCHE PATENTSCHRIFT

(11) **EP 1 273 050 B1**
(45) Veröffentlichungstag und Bekanntmachung des Hinweises auf die Patenterteilung: **02.01.2008**
(21) Anmeldenummer: 01923522.5
(22) Anmeldetag: 20.03.2001
(51) Int. Cl.: H01L 41/083, H01L 41/24

(54) **VERFAHREN UND VORRICHTUNG ZUR HERSTELLUNG VON MEHRSCHICHT-AKTOREN**
METHOD AND DEVICE FOR THE PRODUCTION OF MULTI-LAYERED ACTUATORS
PROCEDE ET DISPOSITIF DE FABRICATION D'ACTIONNEURS MULTICOUCHES

(30) Priorität: 01.04.2000 DE 10016429
(43) Veröffentlichungstag der Anmeldung: 08.01.2003
(73) Patentinhaber: ROBERT BOSCH GMBH, 70442 Stuttgart (DE)
(72) Erfinder: BIESINGER, Thomas, 71277 Rutesheim (DE); SCHULTE, Thomas, 70376 Stuttgart (DE); HAMMER, Marianne, 69517 Gorxheimertal (DE); HENNECK, Stefan, 70839 Gerlingen (DE); SUTER, Warren, 70180 Stuttgart (DE); LINDNER, Friederike, 70839 Gerlingen (DE); HEJTMANN, Georg, 91224 Pommelsbrunn (DE)
(86) Internationale Anmeldenummer: PCT/DE2001/001053
(87) Internationale Veröffentlichungsnummer: WO 2001/075986

(56) Entgegenhaltungen:
- EP-A- 0 530 052
- DE-A- 2 746 732
- PATENT ABSTRACTS OF JAPAN vol. 016, no. 429 (E-1261), 8. September 1992 (1992-09-08) & JP 04 148576 A (NEC CORP), 21. Mai 1992 (1992-05-21) -& JP 04 148576 A (NEC CORP) 21. Mai 1992 (1992-05-21)
- PATENT ABSTRACTS OF JAPAN vol. 014, no. 175 (E-0914), 6. April 1990 (1990-04-06) -& JP 02 028977 A (TOYOTA MOTOR CORP), 31. Januar 1990 (1990-01-31)

## Beschreibung

### Stand der Technik

Mehrschicht-Aktoren bestehen im Allgemeinen aus piezoelektrischen oder elektrostriktiven Keramiken, die beim Anlegen eines elektrischen Feldes eine Längenänderung im Bereich von z.B. 0,1 bis 0,3 % zeigen. Die dazu notwendigen Feldstärken liegen in der Größenordnung von mehreren tausend V/mm. Um derartige Aktoren mit mittleren Ansteuerspannungen von z.B. 100 bis 300 V betreiben zu können, wird ein Mehrschichtaufbau aus alternierenden Keramik/Elektrodenschichten eingesetzt. Die Schichtdicke der gesinterten Einzellagen aus Keramik liegen dabei beispielsweise im Bereich von 80 bis 100 µm, die der gesinterten Elektrodenschichten bei unter 5 µm. Auf Grund der vergleichsweise geringen Schichtdicke lassen sich an den Einzellagen zwischen den Elektroden bereits mit den oben angegebenen Ansteuerspannungen die notwendigen Feldstärken erreichen.

Die Herstellung der Aktoren beinhaltet mehrere Verfahrensschritte:

Zunächst wird beispielsweise keramisches Material in Pulverform zusammen mit organischem Bindemittel und einem Lösungsmittel, z.B. Wasser oder organisches Lösungsmittel, zu einer Suspension verarbeitet, die Schlicker genannt wird. Der Schlicker wird in definierter Schichtdicke in einem Endlosverfahren auf ein Trägerband gegossen und getrocknet. Nach dem Trocknungsschritt kann der getrocknete Schlicker der nunmehr in Form einer flexiblen, handhabbaren Grünfolie vorliegt, von der Trägerfolie abgezogen werden.

Die Grünfolie wird mit oder ohne Trägerband mit einer Metallisierung versehen, um aus der Metallisierung Elektroden zu erzeugen. Das Aufbringen der Metallisierung kann z.B. durch ein Siebdruckverfahren, durch Sputtern oder Aufdampfen realisiert werden. Die mit Metallisierung versehene Grünfolie wird ohne Trägernband gestapelt und laminiert.

Unter "laminieren" versteht man das Verpressen der Folien bei definierter Temperatur. Bei Mehrschicht-Aktoren erfolgt das Stapeln und Laminieren regelmäßig im Vielfachnutzen. D.h. auf jeder Folie ist eine große Anzahl von Einzelelementen untergebracht. Die Folien werden so übereinander gestapelt, dass die Einzelelemente möglichst exakt übereinander liegen. Das Heraustrennen der Aktoren aus Stapeln mit einer Gesamthöhe von bis zu 100 mm ist vergleichsweise aufwendig. Man erhält nach der Trennung ein Mehrschicht-Verbundelement, das einen anschließenden thermischen Prozess, der einen Entbinderungs- und Sinterschritt umfasst, durchlaufen muss. Beim Entbinderungsprozess werden die organischen Bestandteile ausgetrieben. Im nachfolgenden Sinterschritt werden die Keramikpartikel "verbacken". Auf Grund der nicht unproblematischen Trennung ist regelmäßig nach dem Sintervorgang noch ein Nacharbeitungsschritt notwendig, bei welchem die Seitenflächen des Aktors geschliffen werden.

Doch bereits der Laminiervorgang des Folienstapels ist mit Nachteilen behaftet. Für einen qualitativ hochwertigen Laminiervorgang ist es erforderlich den Folienstapel gleichmäßig zu erwärmen und gleichmäßig mit Druck zu beaufschlagen. Bei großen Gesamthöhen und Flächen der Folienstapel ist es nur schwer möglich, den Folienstapel gleichmäßig zu erwärmen bzw. durchzuwärmen. Ein zu langer Vorwärmschritt hätte den Nachteil, dass gegebenenfalls organische Bestandteile aus der Grünfolie Veränderungen unterliegen, z.B. verspröden, was zu Inhomogenitäten in fertiggestellten Bauteilen führen kann. Des Weiteren wird beim Stapeln der Grünfolien immer Luft zwischen den Folienschichten eingeschlossen. Beim Laminieren muss dafür Sorge getragen werden, dass die Luft vollständig entweichen kann. Bei großen Folienstapeln ist die Wahrscheinlichkeit hoch, dass dennoch Luftblasen verbleiben.

Spätestens beim Entbinderungsprozess können derartige Luftblasen das Bauteil zerstören, wenn die nach dem Laminieren in der Luftblase komprimierte Luft sich bei den Entbinderungstemperaturen ausdehnt. Die Folge ist häufig eine Rissbildung im Aktor.

Aus JP 04148576 A ist ein Verfahren zur Herstellung von Mehrschicht-Aktoren bekannt, bei welchem Grünfolien mit darauf aufgebrachten Bereichen aus Metallisierung zur Ausbildung von Elektroden vor einem Sinterschritt zu verpressten Mehrschicht-Verbundelementen verarbeitet werden. Dabei werden aus den Folien einzelne Folienbereiche herausgetrennt, deren Flächen die Querschnittsfläche eines fertig gestellten Aktors definieren. Anschließend werden sie zu einem Folienstapel gestapelt und gesintert.

Schließlich wird in EP 0530052 A1 eine Vorrichtung zur Herstellung eines piezoelektrischen Mehrschicht-Elements beschrieben. Die vorgestellte Vorrichtung weist Trennmittel zum Heraustrennen von Folienbereichen aus einer keramischen Grünfolie auf. In einer Aufnahmevorrichtung werden die herausgetrennten Folienbereiche aufgestapelt.

### Aufgabe und Vorteile der Erfindung

Der Erfindung liegt die Aufgabe zu Grunde, die Herstellung von Mehrschicht-Aktoren insbesondere dahingehend zu verbessern, dass sich höhere Ausbringungsraten realisieren lassen und dabei der Herstellungsaufwand reduziert werden kann.

Die Aufgabe wird durch die Merkmale des Anspruchs 1 und 4 gelöst.

In den Unteransprüchen sind vorteilhafte Weiterbildungen der Erfindung beschrieben.

Die Erfindung geht zunächst von einem Verfahren zur Herstellung von Mehrschicht-Aktoren aus, bei welchem Folien, die ein flexibles Bindemittel umfassen, in welches piezoelektrische und/oder elektrostriktive Materialpartikel eingebettet sind, sogenannte Grünfolien, mit darauf aufgebrachten Bereichen aus Metallisierung zur Ausbildung von Elektroden vor einem Sinterprozess zu verpressten Mehrschicht-Verbundelementen verarbeitet werden. Der Kerngedanke der Erfindung liegt nun darin, dass aus der Grünfolie mit Metallisierung Folienelemente, deren Fläche die Querschnittsfläche eines fertiggestellten Aktors definiert, einzeln herausgetrennt, z.B. ausgeschnitten oder ausgestanzt werden und zur Vorbereitung der Herstellung eines Mehrschicht-Verbundelements die Folienelemente zur einem Folienstapel gestapelt werden. Durch diese Vorgehensweise lassen sich exakt berandete Folienelemente herstellen, womit ein Nacharbeitungsprozess des Bauelements nach dem Sintervorgang entfallen kann, da die Oberflächen ausreichend glatt sind. Die beim Heraustrennen vorgegebene Geometrie der Folienelemente unterliegt zwar einem gewissen Schrumpfungsvorgang durch den anschließenden Sintervorgang, dieser wirkt sich jedoch für alle Folienelemente gleich aus, womit die gewonnene Gleichmäßigkeit der Oberflächen nicht im wesentlichen Umfang verschlechtert wird. Des Weiteren lassen sich bei einer Einzeltrennung komplexe Geometrien, z.B. im Querschnitt n-Eck-förmige, ovale, ringförmige oder runde Aktoren realisieren. Das exakte Heraustrennen von n-Eckförmigen, ovalen, ringförmigen oder runden Aktoren aus laminierten Vielfachnutzen mit vergleichsweise großer Gesamthöhe bereitet regelmäßig große Schwierigkeiten. Außerdem lassen sich Folienstapel, die bis auf den Schrumpfungsanteil die Fläche der späteren Aktoren besitzen, besser laminieren, da sich eine günstigere Verteilung des Laminierdrucks einstellt, Höhenunterschiede beim Laminieren zwischen mit Elektroden versehenen Bereichen und elektrodenlosen Bereichen der Grünfolie sich kaum nachteilig auswirken, der Stapel schneller und gleichmäßiger durchwärmbar ist und zudem Luft aus Zwischenräumen zwischen den gestapelten Folienelemente leichter entweichen kann. Darüber hinaus können fehlerhaft gedruckte Elektroden leicht beim Austrennen bereits aussortiert werden, was zu einer deutlichen Minimierung von Aktoren führt, die als Ausschuss ausgesondert werden müssen.

Um den Stapelvorgang der Folienelemente effektiv zu gestalten, wird jedes ausgetrennte Folienelement unmittelbar nach Beendigung des Trennvorgangs vor dem Heraustrennen des nächsten Folienelements aufgestapelt. Dabei ist es bevorzugt, dass die Folienelemente in der Lage, so wie Sie ausgetrennt werden, nach möglichst kurzer Distanz die Aufstapelstelle erreichen. Denn somit kann vermieden werden, dass das Folienelement beispielsweise vor dem Aufstapeln verkippt.

Bei einer Vorrichtung zur Herstellung von Mehrschicht-Aktoren aus Grünfolie mit vorzugsweise darauf aufgebrachten Bereichen aus Metallisierung für die Ausbildung von Elektroden, welche eine Trenneinrichtung mit einem Trennwerkzeug, wie z.B. eine Schneid- oder Stanzeinrichtung für eine Trennung der Grünfolien und eine anschließende Stapeleinheit umfasst, liegt der Kerngedanke der Erfindung darin, dass die Trenneinrichtung dazu ausgelegt sind, aus der Grünfolie Folienelemente einzeln herauszutrennen, deren Fläche die Querschnittsfläche des fertig gestellten Aktors definiert und die ausgetrennten Folienelemente unmittelbar nach Abschluss des Trennvorgangs in einen Folienstapel aufzunehmen. Auf diese Weise lässt sich das Austrennen von Folienelementen und deren Aufstapeln quasi als ein Arbeitsschritt realisieren, was sich positiv auf den Herstellungsaufwand der Aktoren auswirkt.

Gemäß der Erfindung weist die Trenneinrichtung ein Trennwerkzeug auf, an welches eine Stapeleinheit anschließt, in welcher die ausgetrennten Folienelemente aufgenommen werden. Dies stellt eine vergleichsweise einfache Möglichkeit dar, das Aufstapeln der Folienelemente unmittelbar dem Trennvorgang nachzuschalten.

Weiter umfasst die Stapeleinheit eine Ausnehmung zur Aufnahme der Folienelemente, deren Querschnitt der Fläche der ausgetrennten Folienelemente entspricht, und in welcher ein Stempelelement geführt ist, dessen Position sich der Folienstapelhöhe angleicht, d.h. die aktuelle Position des Stempels wird von der Folienstapelhöhe bestimmt. Durch diese Vorgehensweise wird zunächst eine exakte Stapelung der Folienelemente erreicht, da sie in der Ausnehmung positionsgenau übereinandergelegt werden. Des Weiteren wird durch die Nachführung des Stempelelements dafür gesorgt, dass der Weg für ausgetrennte Folienelemente zur Stapelstelle immer gleichbleibend gering ist. Dementsprechend kann sicher vermieden werden, dass ein ausgetrenntes Folienelement bis zur Stapelstelle verkippt.

Um die Stapeleinheit auch zum Laminieren der Folienelemente nutzen zu können, wird im Weiteren vorgeschlagen, dass die Stapeleinheit beheizbar ist.

In diesem Zusammenhang ist es bevorzugt, dass das Stempelelement in der Stapeleinheit mit einem entsprechenden Gegenstempel, z.B. einem ohnehin vorhandenen Stanzstempel für das Laminieren der Folienelemente einsetzbar ist. Durch diese Maßnahme ist es nicht notwendig, einen Folienstapel für das Laminieren in ein weiteres Werkzeug zu verbringen. Vorzugsweise lässt sich das Stempelelement und gegebenenfalls der Gegenstempel zum Aufbringen eines vordefinierten Drucks auf den Folienstapel hydraulisch bewegen.

Eine weitere bevorzugte Ausgestaltung der Erfindung sieht vor, in den Stanzstempel einen oder mehrere Belüftungskanäle einzubringen. Damit kann verhindert werden, dass es bei sehr hohen Stanzgeschwindigkeiten beim Zurückziehen des Stanzstempels nach erfolgtem Stanzvorgang zum Entstehen eines Unterdruckes in der Matrize kommt, was zur Folge haben kann, dass bereits gestanzte Folienteile aufgewirbelt werden.

In einer bevorzugten Ausgestaltung der Erfindung umfasst das Trennwerkzeug weiter eine Schneidkante, die an der Aufnahmeseite der Ausnehmung der Stapeleinheit angeordnet ist. Bei einer alternativen Lösung, die gleichfalls einfach ist, umfasst das Trennwerkzeug einen Stanzstempel, der über der Aufnahmeseite der Ausnehmung der Stapeleinheit angeordnet ist.

### Zeichnungen

Verschiedene Ausführungsbeispiele der Erfindung sind in den Zeichnungen dargestellt und unter Angabe weiterer Vorteile und Einzelheiten näher erläutert. Es zeigen
- Figur 1a bis c: das Herstellungsverfahren eines Mehrschicht-Aktors in drei schematisch dargestellten Verfahrensstadien verdeutlicht,
- Figur 2: eine Vorrichtung zum Ausstanzen und Laminieren von Folienelementen aus einer Grünfolie in einer schematischen Seitenansicht,
- Figur 3: eine Vorrichtung zum Ausschneiden und Laminieren von Folienelementen aus einer Grünfolie in einer schematischen Seitenansicht und
- Figur 4a bis c: ein bislang eingesetztes Verfahren zur Herstellung von Aktoren durch drei schematisch dargestellte Verfahrensstadien verdeutlicht.

### Beschreibung der Ausführungsbeispiele

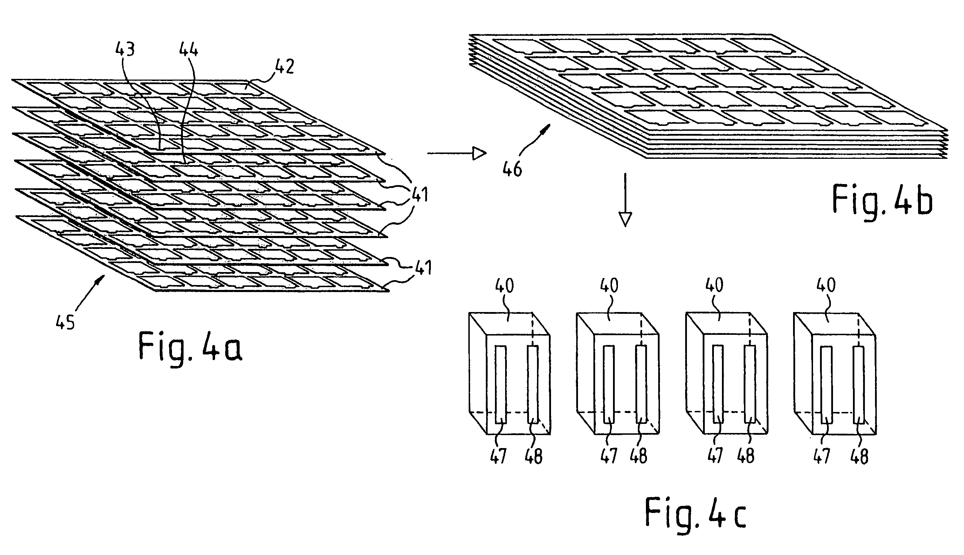

Die Figuren 4a bis c veranschaulichen die herkömmliche Herstellung von Mehrschicht-Aktoren durch drei schematisch dargestellte Verfahrensstadien. Zunächst werden Grünfolien 41 erzeugt und mit metallischen Elektroden 42 versehen. Die Grünfolien mit Elektroden 42 werden gemäß 4a derart übereingestapelt, dass die Elektrodenflächen in vertikaler Richtung jeweils übereinander liegen und von Grünfolie zu Grünfolie alternierend Anschlussnasen 43, 44 nach außen geführt sind. Ein solcher Folienstapel 45 wird gemäß Figur 4b laminiert, d.h. der Folienstapel wird unter Druck und erhöhten Temperatur verpresst. Die Gesamthöhe von laminierten Folienstapeln im Vielfachnutzen kann bis zu 100 mm betragen.

Das Laminieren derart großer Stapelblöcke ist technologisch nicht unproblematisch. Schwierig ist bereits das Aufbringen eines gleichmäßigen Flächendrucks auf die Grünfolien, da der Übergang von Elektrodenflächen zu elektordenfreien Bereichen an der Grünfolie zu Höhenunterschieden führt, die im Folienstapel unterschiedliche Druckprofile verursachen.

Des Weiteren ist es kaum möglich einen großen Folienstapel gleichmäßig zu erwärmen bzw. durchzuwärmen. Bei einer zu langen Erwärmung von beispielsweise außen liegenden Bereichen des Folienstapels kann es zu einer Versprödung des in der Regel organischen Bindemittels kommen. Dies führt zu Inhomogenitäten im laminierten Stapel, was sich ungünstig auf die Entbinderung und den Sintervorgang auswirken kann.

Schließlich lässt sich beim Stapeln der Grünfolien das Einschließen von Luftblasen nicht immer vermeiden. Der Laminiervorgang sollte dann so ausgeführt werden, dass die eingeschlossene Luft entweichen kann. Bei großen Stapeln ist jedoch die Wahrscheinlichkeit hoch, dass Luftblasen verbleiben. Eingeschlossene Luftblasen haben, wie bereits oben erwähnt, oftmals eine Zerstörung einzelner Bauteile beim Entbinderungsprozess zur Folge.

Aus einem laminierten Folienstapel werden entsprechend Figur 4c Mehrschicht-Verbundelemente 40 herausgeschnitten. An den Mehrschicht-Verbundelementen 40 sind die alternierend herausgeführten Elektrodennasen durch Rechtecke 47, 48 schematisch dargestellt.

Die ausgetrennten Mehrfach-Verbundelemente 40 werden in einem nachfolgenden Verfahrensschritt (nicht gezeigt) gesintert und regelmäßig nachgearbeitet. Denn beim Austrennen der Mehrschicht-Verbundelemente 40 aus dem Folienstapel entstehen im Allgemeinen unzureichend grobe Oberflächen, die beispielsweise durch Schleifen eingeebnet werden müssen.

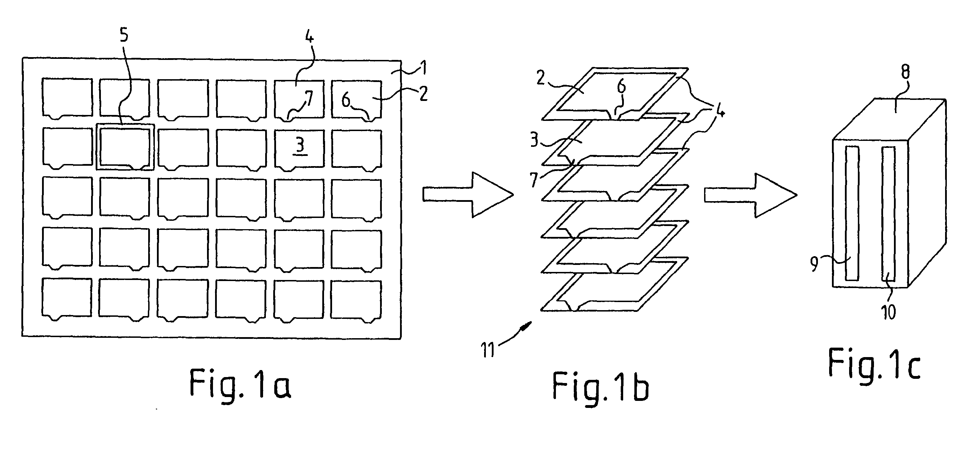

Die Figuren 1a bis c verdeutlichen ein Verfahren durch drei schematisch dargestellte Prozessstadien, bei welchem die Nachteile des herkömmlichen Verfahrens vermieden werden können.

Ausgangspunkt des Verfahrens ist wiederum die Herstellung von Grünfolien 1, auf welchen Elektroden 2, 3 aufgebracht sind (vergleiche Figur 1a).

Aus einer Grünfolie 1 mit Elektroden 2, 3 werden nun einzeln Folienelemente 4, z.B. ausgestanzt und gemäß Figur 1b übereinander gestapelt.

In Figur 1a ist schematisch ein Stanzschnitt durch ein eingezeichnetes Rechteck 5 angedeutet.

Die Folienelemente 4 werden wiederum so übereingestapelt, dass an den darauf positionierten Elektroden 2, 3 alternierend Anschlussnasen 6, 7 bis an eine äußere Schnittkante geführt sind.

Ein solcher Folienstapel aus Folienelementen 4, wird nun einzeln laminiert, so dass ein Mehrschicht-Verbundelement 8 gemäß Figur 1c entsteht. Am Mehrschicht-Verbundelement 8 sind die herausgeführten Anschlussnasen 6, 7 durch Rechtekke 9, 10 verdeutlicht. Über die Anschlussnasen 6, 7 kann jede Schicht des Aktors mit Spannung beaufschlagt werden.

Das Laminieren von Folienstapeln 11 gemäß Figur 1b ist vergleichsweise einfach, da der in der Querschnittsfläche kleine Folienstapel 11 sich gleichmäßig erwärmen lässt, der Einschluss von Luftblasen unproblematisch ist und zudem die Beaufschlagung des Folienstapels mit einem homogenen Flächendruck leichter realisierbar ist, da die elektrodenfreien Bereiche am Rand des Folienstapels liegen.

Ein Mehrschicht-Verbundelement 8 gemäß Fig. 1c bedarf zur Herstellung eines fertigen Mehrschicht-Aktors lediglich einem Entbinderungs- und Sinterschritt. Eine Nachbearbeitung von Oberflächen ist im besten Fall nicht mehr nötig, da die Folienelemente einzeln exakt genug herausgetrennt und gestapelt werden können, um gleichmäßige Seitenflächen zu erhalten.

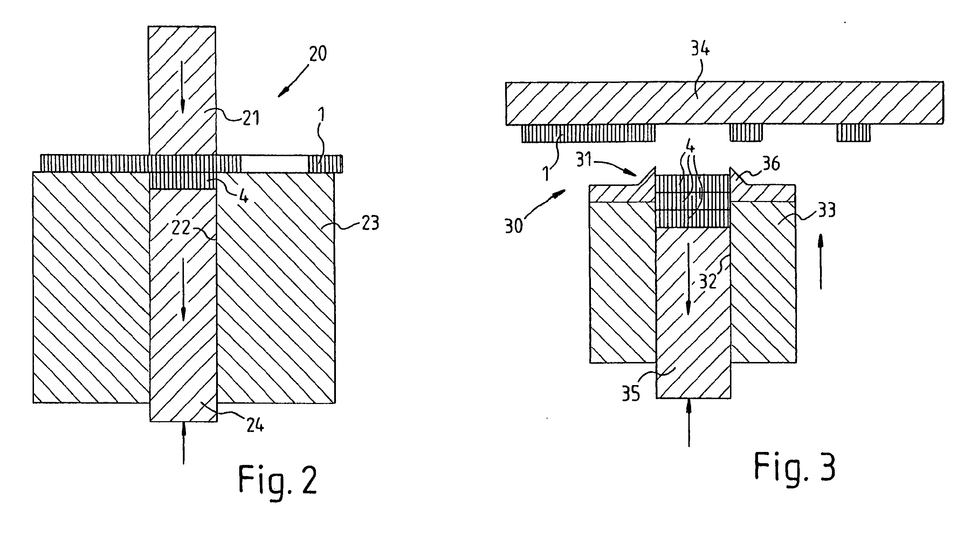

In Figur 2 ist eine Vorrichtung 20 zum Ausstanzen von Folienelementen 4 in einer schematischen Schnittansicht dargestellt. Die Folienelemente 4 werden mit einem Stanzstempel 21 herausgetrennt. Hierzu wird entweder die Grünfolie 1 mit Elektroden unter der Stanzvorrichtung bewegt oder die Stanzvorrichtung in Bezug auf die Grünfolie 1 positioniert.

Unmittelbar unterhalb des Stanzstempels 21 ist eine Ausnehmung 22 in einer Stapeleinheit 23 vorgesehen. Die Ausnehmung 22 entspricht im Querschnitt im Wesentlichen der Fläche und Form der ausgestanzten Folienelemente 4, so dass ausgestanzte Folienelemente 4 in die Ausnehmung 22 fallen.

Damit findet unmittelbar nach dem Ausstanzvorgang vor dem Ausstanzen des nächsten Folienelements eine exakte Stapelung der Folienelemente statt.

In der Ausnehmung 22 ist ein z.B. hydraulisch bewegbarer Stapelstempel 24 angeordnet, dessen Position sich dem wachsenden Folienstapel in der Ausnehmung 22 anpasst. Der Querschnitt des Stapelstempels 22 entspricht vorzugsweise dem Querschnitt der Ausnehmung 22.

Durch diese Vorgehensweise lässt sich eine kontrollierte Stapelung der Folienelemente 4 erzielen. Sobald der Folienstapel die gewünschte Anzahl von Folienelementen aufweist, kann in der Stapeleinheit 23 auch der Laminiervorgang stattfinden. Hierzu wird die Stapeleinheit 23 mit nicht dargestellten Heizmitteln erwärmt, wobei über den Stapelstempel und einen geeigneten Gegenstempel, z.B. dem Stanzstempel 21, Druck auf den Folienstapel aufgebracht wird.

Das Ergebnis ist dann ein Mehrschicht-Verbundelement, welches sehr homogen laminiert ist und zudem bereits vergleichsweise exakte Oberflächen aufweist.

In Figur 3 ist eine alternative Vorrichtung 30 zum Heraustrennen von Folienelementen 4 dargestellt. Die Folienelemente werden bei dieser Vorrichtung mit Hilfe einer Schneidkante 36 an einem Schneidwerkzeug 31 herausgeschnitten, das um die Aufnahmeseite einer daran anschließenden Ausnehmung 32 an einer Stapeleinheit 33 angeordnet ist. Das Schneidwerkzeug 31 und die Ausnehmung 32 haben den gleichen Querschnitt.

Vor dem Schneidwerkzeug 31 ist eine Grünfolie 1 an einem Trägerelement 34 angeordnet.

Zum Herausschneiden eines Folienelements 4 wird die Stapeleinheit 33 mit darauf angeordnetem Schneidwerkzeug 31 gegen die Grünfolie 1 an geeigneter Position gefahren, bis die Grünfolie 1 völlig durchtrennt ist. Ebenso kann auch die Grünfolie 1 in Bezug auf das Schneidwerkzeug 31 bewegt werden. Die Positionierung des Schneidschnittes auf der Grünfolie kann entweder durch Bewegen der Folie oder durch Bewegen des Schneidwerkzeuges erfolgen.

Ausgeschnitte Folienelemente 4 werden unmittelbar von der dem Schneidwerkzeug 31 nachfolgenden Ausnehmung 32 aufgenommen.

Um eine definierte Stapelung zu erzielen, wird auch bei dieser Ausführungsform ein hydraulisch geführter Stapelstempel 35 eingesetzt, der sich der Höhe der gestapelten Folienelmente 4 anpasst. Der Stapelstempel 35 hat den gleichen Querschnitt wie die Ausnehmung 32.

Sofern die gewünschte Anzahl von Folienelementen 4 in der Stapeleinheit 33 aufgenommen ist, kann darin auch das Laminieren der Folienelemente 4 erfolgen. Hierzu kann z.B. auf der Seite des Schneidwerkzeuges 31 ein Gegenstempel (nicht gezeigt) eingesetzt werden, so dass die Folienelemente 4 über den Stapelstempel 35 und den Gegenstempel mit einem definierten Druck beaufschlagt werden können. Die erforderliche gleichmäßige Erwärmung der Folienelemente lässt sich durch Erwärmen der Stapeleinheit 33 erreichen.

Auch mit der Vorrichtung 30 zum Schneiden der Folienelemente lassen sich homogen laminierte Mehrschicht-Verbundelemente erzeugen, die lediglich entbindert und gesintert werden müssen, um einen Mehrschicht-Aktor zu erhalten.

## Patentansprüche

1. Verfahren zur Herstellung von Mehrschicht-Aktoren, bei welchem Folien, die ein flexibles Bindemittel umfassen, in welches piezoelektrische und/oder elektrostriktive Materialpartikel eingebettet sind, sogenannte Grünfolien (1), mit darauf aufgebrachten Bereichen aus Metallisierung zur Ausbildung von Elektroden (2, 3) vor einem Sinterschritt zu verpressten Mehrschicht-Verbundelementen (8) verarbeitet werden, wobei aus der Grünfolie (1) mit Metallisierung Folienelemente (4), deren Fläche die Querschnittsfläche eines fertig gestellten Aktors definiert, einzeln herausgetrennt werden und zur Vorbereitung der Herstellung eines Mehrschicht-Verbundelements (8) zu einem Folienstapel in einer Stapeleinheit (23, 33) gestapelt werden, **dadurch gekennzeichnet, dass** die Stapeleinheit (23, 33) eine Ausnehmung (22, 32) zur Aufnahme von Folienelementen (4) umfasst, deren Querschnitt der Fläche der ausgetrennten Folienelemente entspricht, und in welcher ein Stapelstempel (24, 35) derart geführt wird, dass dessen Position sich an die Folienstapelhöhe angleicht.

2. Verfahren nach Anspruch 1, **dadurch gekennzeichnet, dass** jedes ausgetrennte Folienelement (4) vor dem Heraustrennen des nächsten Folienelements aufgestapelt wird.

3. Verfahren nach einem der vorhergehenden Ansprüche, **dadurch gekennzeichnet, dass** die Herstellung der Mehrschicht-Verbundelemente (8) durch separates Verpressen eines Folienstapels (11) unter Wärme erfolgt.

4. Vorrichtung zur Herstellung von Mehrschicht-Aktoren aus Grünfolie (1), welche Trennmittel (20, 30) für eine der Grünfolien umfasst, insbesondere zur Durchführung des Verfahrens nach einem der vorhergehenden Ansprüche, wobei die Trennmittel (20, 30) dazu ausgelegt sind, aus der Grünfolie (1) Folienelemente (4), deren Fläche die Querschnittsfläche eines fertig gestellten Aktors definiert, einzeln auszutrennen und ein ausgetrenntes Folienelement (4) unmittelbar im Anschluss an den Trennvorgang vor dem Heraustrennen des nächsten Folienelements in einen Folienstapel aufzunehmen, und wobei die Trennmittel ein Trennwerkzeug (21, 31) aufweisen, an welches eine Stapeleinheit (23, 33) anschließt, in welcher die Folienelemente (4) aufgenommen werden, **dadurch gekennzeichnet, dass** die Stapeleinheit (23, 33) eine Ausnehmung (22, 32) zur Aufnahme von Folienelementen (4) umfasst, deren Querschnitt der Fläche der ausgetrennten Folienelemente entspricht, und in welcher ein Stapelstempel (24, 35) geführt ist, dessen Position sich an die Folienstapelhöhe angleicht.

5. Vorrichtung nach Anspruch 4, **dadurch gekennzeichnet, dass** die Stapeleinheit (23, 33) erwärmbar ist.

6. Vorrichtung nach Anspruch 4 oder 5, **dadurch gekennzeichnet, dass** das Stempelelement (24, 35) in der Stapeleinheit (23, 33) mit einem entsprechenden Gegenstempel für das Laminieren der Folienelemente 4 einsetzbar ist.

7. Vorrichtung nach einem der Ansprüche 4 bis 6, **dadurch gekennzeichnet, dass** das Trennwerkzeug eine Schneidkante (36) umfasst, die an einer Aufnahmeseite der Ausnehmung (32) der Stapeleinheit (33) angeordnet ist.

8. Vorrichtung nach einem der Ansprüche 4 bis 7, **dadurch gekennzeichnet, dass** das Trennwerkzeug einen Stanzstempel (21) umfasst, der über einer Aufnahmeseite der Ausnehmung (22) der Stapeleinheit (23) angeordnet ist.

## Claims

1. Method for the production of multi-layered actuators, in which sheets comprising a flexible binder, into which are embedded piezoelectric and/or electrostrictive material particles, so-called green sheets (1), with regions applied thereon and composed of metallization for the formation of electrodes (2, 3), are processed before a sintering step to form pressed multi-layered composite elements (8), wherein sheet elements (4), the area of which defines the cross-sectional area of a completed actuator, are separated out individually from the green sheet (1) with metallization and, in order to prepare for the production of a multi-layered composite element (8), are stacked to form a sheet stack in a stacking unit (23, 33), **characterized in that** the stacking unit (23, 33) comprises a cutout (22, 32) for receiving sheet elements (4), the cross section of which corresponds to the area of the separated-out sheet elements and in which a stacking ram (24, 35) is guided in such a way that its position is adapted to the sheet stack height.

2. Method according to Claim 1, **characterized in that** each separated-out sheet element (4) is stacked before the next sheet element is separated out.

3. Method according to one of the preceding claims, **characterized in that** the multi-layered composite elements (8) are produced by separately pressing a sheet stack (11) under heat.

4. Device for the production of multi-layered actuators from green sheet (1), which comprises separating means (20, 30) for one of the green sheets, in particular for carrying out the method according to one of the preceding claims, wherein the separating means (20, 30) are designed to individually separate out from the green sheet (1) sheet elements (4), the area of which defines the cross-sectional area of a completed actuator, and to receive a separated-out sheet element (4) into a sheet stack directly after the separating operation before the next sheet element is separated out, and wherein the separating means have a separating tool (21, 31), to which a stacking unit (23, 33) is adjacent, in which the sheet elements (4) are received, **characterized in that** the stacking unit (23, 33) comprises a cutout (22, 32) for receiving sheet elements (4), the cross section of which corresponds to the area of the separated-out sheet elements and in which a stacking ram (24, 35) is guided, the position of which is adapted to the sheet stack height.

5. Device according to Claim 4, **characterized in that** the stacking unit (23, 33) can be heated.

6. Device according to Claim 4 or 5, **characterized in that** the ram element (24, 35) in the stacking unit (23, 33) can be used with a corresponding counter-ram for the lamination of the sheet elements (4).

7. Device according to one of Claims 4 to 6,
**characterized in that** the separating tool comprises a cutting edge (36), which is arranged at a receiving side of the cutout (32) of the stacking unit (33).

8. Device according to one of Claims 4 to 7,
**characterized in that** the separating tool comprises a stamping ram (21), which is arranged above a receiving side of the cutout (22) of the stacking unit (23).

## Revendications

1. Procédé de fabrication d'actionneurs multicouches, selon lequel on traite des films comportant un agent de liaison souple intégrant des particules de matière piézo-électrique et/ou électrostrictive, c'est-à-dire des films non cuits (1), avec des zones rapportées, métallisées pour former des électrodes (2, 3), sont comprimées en éléments composites multicouches (8) avant une étape de frittage,
et à partir du film non cuit (1), métallisé on dégage séparément des éléments de film (4), dont la surface définit la surface de la section d'un actionneur terminé, et ont les empile pour préparer la fabrication d'un élément composite multicouches (8), sous la forme d'une pile de films dans une unité d'empilage (23, 33),
**caractérisé en ce que**
l'unité d'empilage (23, 33) comporte une cavité (22, 32) pour recevoir des éléments de film (4) dont la section correspond à la surface des éléments de film dégagés, et dans laquelle est guidé un poinçon d'empilage (24, 35) dont la position est adaptée à la hauteur de la pile de films.

2. Procédé selon la revendication 1,
**caractérisé en ce qu'**
on empile chaque élément de film séparé (4) avant de dégager l'élément de film suivant.

3. Procédé selon l'une des revendications précédentes,
**caractérisé en ce que**
la fabrication des éléments composites multicouches (8) se fait par compression séparée d'une pile de films (11), à chaud.

4. Dispositif de fabrication d'actionneurs multicouches à partir de films non cuits (1), comprenant des moyens de séparation (20, 30) pour l'un des films non cuits, notamment pour la mise en oeuvre du procédé selon l'une des revendications précédentes, selon lequel les moyens de séparation (20, 30) sont conçus pour séparer à partir du film non cuit (1), un à un des éléments de film (4) dont la surface définit la surface de la section d'un actionneur terminé, et un élément de film (4) ainsi dégagé, directement après l'opération de séparation et avant le dégagement de l'élément de film suivant, est placé dans une pile de films et les moyens de séparation comportent un outil de séparation (21, 31) auquel fait suite une unité d'empilage (23, 33) recevant les éléments de film (4),
**caractérisé en ce que**
l'unité d'empilage (23, 33) comporte une cavité (22, 32) pour recevoir les éléments de film (4), dont la section correspond à la surface des éléments de film, dégagés, et qui guide un poinçon d'empilage (24, 35) dont la position s'adapte à la hauteur de la pile de film.

5. Dispositif selon la revendication 4,
**caractérisé en ce que**
l'unité d'empilage (23, 33) est chauffée.

6. Dispositif selon l'une des revendications 4 ou 5,
**caractérisé en ce que**
l'élément de poinçon (24, 35) est appliqué à l'unité d'empilage (23, 33) avec un contre-poinçon correspondant pour laminer les éléments de film (4).

7. Dispositif selon l'une des revendications 4 à 6,
**caractérisé en ce que**
l'outil de séparation comporte une arête de coupe (36) prévue sur le côté de réception de la cavité (32) de l'unité d'empilage (33).

8. Dispositif selon l'une des revendications 4 à 7,
**caractérisé en ce que**
l'outil de séparation comporte un poinçon de découpe (21) prévu au niveau du côté de réception de la cavité (22) de l'unité d'empilage (23).
